Europäisches Patentamt

European Patent Office

Office européen des brevets

(19)

(11) Numéro de publication: **0 204 635 B1**

(12) **FASCICULE DE BREVET EUROPEEN**

(45) Date de publication de fascicule du brevet:
08.05.91

(51) Int. Cl.⁵: **H03M 13/00**, G11B 20/18,
//G06F11/10

(21) Numéro de dépôt: 86401185.3

(22) Date de dépôt: 03.06.86

(54) **Procédé de transmission en blocs de mots d'information numérique.**

(30) Priorité: 05.06.85 FR 8508481

(43) Date de publication de la demande:
10.12.86 Bulletin 86/50

(45) Mention de la délivrance du brevet:
08.05.91 Bulletin 91/19

(84) Etats contractants désignés:
AT BE CH DE GB IT LI LU NL SE

(56) Documents cités:
EP-A- 0 129 224
GB-A- 2 061 575
GB-A- 2 140 178
US-A- 3 439 331
US-A- 4 336 612

IBM TECHNICAL DISCOSURE BULLETIN, vol.
17, no. 2, juillet 1974, pages 473-475, New
York, US; A.M. PATEL: "Coding scheme for
multiple sections error correction"

ELECTRONIC DESIGN, vol. 31, no. 1, 6 janvier
1983, pages 269-274, Waseca, MN, Denville,
NJ, US; "32-bit EDAC chips fix sigle-bit errors efficiently"

(73) Titulaire: **Etablissement Public de Telediffusion dit "Télédiffusion de France"**
**21, 27 rue Barbès**
**F-92542 Montrouge Cédex(FR)**

(72) Inventeur: **Komly, Alain**
**6, rue Copreaux**
**F-75015 Paris(FR)**
Inventeur: **Maillard, Michel**
**42, Avenue du Maréchal Leclerc**
**F-28130 Maintenon(FR)**
Inventeur: **Viallevieille, Alain**
**7 Ter, rue Saint Charles**
**F-78000 Versailles(FR)**
Inventeur: **Weisser, Alain**
**31, rue Brissard**
**F-92140 Clamart(FR)**

(74) Mandataire: **Mongrédien, André et al**
**c/o BREVATOME 25, rue de Ponthieu**
**F-75008 Paris(FR)**

IEEE TRANSACTIONS ON CONSUMER ELEC-
TRONICS, vol. CE-30, no. 3, août 1984, pages
353-359, IEEE, New York, US; T. ARAI et al.:
"High capability error correction LSI for CD
player and CD ROM"

JOURNAL OF THE INSTITUTION OF ELEC-
TRONIC AND RADIO ENGINEERS, vol. 55, no.
4, avril 1985, pages 139-144, Londres, GB;
M.A. PARKER: "A combined error correction
and channel code scheme for digital video
tape recorders"

THE BRITISH KINEMATOGRAPHY SOUND
AND TELEVISION SOCIETY JOURNAL, vol. 62,
no. 11, novembre 1980, pages 570-580, Londres, GB; K. YOKOYAMA et al.: "An experimental digital videotape recorder"

W.W. Peterson, E.J. Weldon Jr.,
"Error-Connecting Codes", 2e édition, 1972,
pages 117-120, 131, 220, 357, 358

## Description

La présente invention a pour objet un procédé de transmission en blocs de mots d'information numérique. Elle concerne plus particulièrement une technique de codage et de décodage dans laquelle on forme des blocs d'émission composés chacun d'une suite de mots d'information numérique et de mots de redondance associés, ces mots de redondance étant construits de manière à détecter et à corriger, à la réception, des paquets d'erreurs de grande longueur, telles que celles rencontrées en enregistrement numérique sur bande magnétique.

De manière classique, dans le domaine de l'enregistrement numérique sur bande magnétique, l'information à enregistrer est organisée en trames comprenant chacun un mot de synchronisation, un mot d'identification, un ou plusieurs mots d'information et un code détecteur d'erreur. Ce code détecteur d'erreur peut ne pas détecter toutes les erreurs.

Pour améliorer les capacités de détection et de correction des erreurs, il est connu de regrouper les trames en ensembles de trames et de relier les informations homologues (i.e. les bits de même rang) des trames d'un même ensemble par des relations mathématiques simples telles que la parité de la somme des bits homologues. Il est également connu de former un bloc d'émission en entrelaçant les suites de trames de plusieurs ensembles liés de façon à rendre les probabilités d'erreurs sur les trames d'un même ensemble indépendantes les unes des autres.

L'article "Improved two channel PCM tape recorder for professional use" de K. Tanaka et al présenté au 64ème congrès de la Société des Ingénieurs Audio, New-York, Novembre 1979 décrit un tel procédé de transmission en blocs de mots d'information numérique. L'enregistrement est réalisé sur une bande magnétique à 8 pistes dont 6 sont affectées aux mots d'information et 2 aux mots de redondance reliant les informations homologues des trames d'un même ensemble. Ces mots de redondance sont obtenus à l'aide d'un code du type Reed-Solomon.

Ce procédé connu n'est pas pleinement satisfaisant car le code de Reed-Solomon est un code complexe. La détection et la correction des erreurs au moyen de ce code demandent donc des calculs longs et compliqués. Par ailleurs, la capacité de correction du procédé décrit, c'est-à-dire la probabilité d'avoir une erreur non corrigeable, est proportionnelle à $p^3$ lorsque la probabilité d'avoir une erreur est égale à p. Cette capacité de correction n'est pas très élevée. Le rapport performance à complexité apparaît donc très moyen.

On connait des procédés de transmission dans lesquels la probabilité d'erreur non corrigeable est proportionnelle à $p^4$. Un tel procédé est décrit dans la demande de brevet français n° 2 467 510 intitulée "Procédé et dispositif de transmission d'une séquence de mots d'information numérique".

Dans ce procédé, les mots d'information sont séparés en une séquence de mots d'information pairs et une séquence de mots d'information impairs. Ces séquences sont codées et transmises avec un décalage temporel. Cette technique permet d'éviter qu'un défaut affectant le canal de transmission, ou le support d'enregistrement, ne provoque une erreur sur deux mots d'information consécutifs. Un mot d'information reconnu erroné peut ainsi être corrigé ou, si la correction n'est pas possible, interpolé à partir du mot d'information précédent et du mot d'information suivant. Cette interpolation n'a évidemment un sens que si les mots d'information successifs sont corrélés, ce qui est notamment le cas en enregistrement numérique d'un signal sonore.

Dans ce procédé, le format de transmission ou d'enregistrement présente une structure glissante c'est-à-dire que l'entrelacement des trames est tel qu'il est impossible de définir des blocs indépendants comme c'est le cas dans l'article cité. Ceci a pour conséquence une complication lors du montage électronique de programmes sonores, notamment due au fait que les structures glissantes sont brisées au point de montage, ce qui induit une perte de capacité de correction.

D'autre part, on pourra se reporter au document "IBM Technical Disclosure Bulletin", vol. 17, N° 2, dans lequel est décrit un procédé de codage utilisant un code correcteur d'erreur et un code détecteur d'erreur.

On pourra se reporter également au document "Journal of the Institution of Electronic and Radio Engineers", vol. 55, N° 4, avril 1985, dans lequel est décrite l'utilisation d'un code de Hamming.

Il est également connu du document constitué par l'article de W.W. Peterson, E.J. Weldon, Jr "Error-Correcting Codes", 2ième édition, 1972, d'utiliser un code de Hamming généralisé basé sur des éléments binaires et des éléments non binaires.

L'invention a notamment pour but de remédier aux inconvénients des procédés de transmission connus et pour objectif un procédé de transmission en blocs indépendants, afin de pouvoir faire du montage facilement, en particulier du montage électronique.

L'invention a également pour objectif un procédé de transmission apte à résister à une perte d'informations survenant sur toute la largeur d'une bande magnétique sur une longueur de 5 à 10 mm environ, dans le cas où l'enregistrement est effectué en parallèle sur plusieurs pistes magnétiques, et apte à résister à la perte complète d'une piste magnétique lorsque les informations sont réparties par exemple sur quatre pistes magnétiques.

L'invention a aussi pour objectif un procédé de transmission permettant de corriger au moins trois erreurs, c'est-à-dire un procédé de transmission dans lequel la probabilité d'erreur non corrigible est proportionnelle à $p^4$, lorsque la probabilité d'avoir une erreur est égale à p.

L'invention a enfin pour objectif de détecter et de corriger des erreurs non détectées par les codes détecteur d'erreur protégeant les mots d'information et de redondance.

De manière précise, l'invention a pour objet un procédé de transmission en blocs de mots d'information numériques ayant chacun une longueur de $n_1$ bits, où $n_1$ est un entier, ledit procédé consistant à ajouter successivement aux mots d'information à transmettre des mots d'un code correcteur d'erreur et des mots d'un code détecteur d'erreur, procédé dans lequel :

- le code correcteur d'erreur est un code de Hamming au moyen duquel on ajoute k mots de redondance à chaque suite de $n_2$-k ($n_2$>k) mots d'information consécutifs, lesdits $n_2$-k mots d'information formant avec les k mots de redondance un ensemble de mots appelé ensemble lié, chaque mot de redondance ayant $n_1$ bits et, pour chaque rang i, où $1 \leq i \leq n_1$, les k bits de rang i des mots de redondance sont des bits de redondance des $n_2$-k bits de rang i des $n_2$-k mots d'information, ledit codage étant réalisé par une matrice de Hamming dont les vecteurs colonne sont choisis de manière à permettre la correction d'un sous-ensemble déterminé des erreurs possibles,
- le code détecteur d'erreur est appliqué à des suites de mots d'information ou à des suites de mots de redondance, les mots d'une même suite appartenant à des ensembles liés différents, chaque bloc transmis comprenant une pluralité de suites de $n_2$-k mots d'information et les mots de codes détecteur et correcteur d'erreur associés,

procédé caractérisé en ce que pour un signal enregistré sur un support à P pistes en parallèle les k bits de redondance associés à $n_2$-k bits d'information sont produits en utilisant une matrice de Hamming à $n_2$ colonnes et k lignes dont toute suite de k vecteurs d'indice i, i + P, i + 2P,..., i + (k-1)P, où i, P sont entiers et i + (k-1)P $\leq n_2$, forme un système linéairement indépendant ; chaque ensemble lié d'un bloc étant réparti sur plusieurs pistes, un mot de code étant ainsi distribué sur plusieurs pistes tandis que plusieurs éléments dudit mot sont enregistrés sur la même piste.

Les mots de redondance sont obtenus de préférence par un code de Hamming étendu, c'est-à-dire de la forme ($2^m$, $2^m$-m-1), où m est un entier. Mais il est également possible d'utiliser un code de Hamming normal de la forme ($2^m$-1, $2^m$-m-1). Dans les deux cas, le code peut être raccourci. Il est alors respectivement de la forme ($2^m$-p, $2^m$-m-1-p) ou de la forme $2^m$-1-p, $2^m$-m-1-p). Ce raccourcissement consiste à forcer la valeur de p bits de chaque mot d'information à une valeur binaire particulière, en général la valeur "0".

De manière préférée, un bloc transmis comporte plusieurs ensembles liés entrelacés. Les mots homologues de chaque ensemble forment un groupe. Ces mots homologues sont répartis dans une ou plusieurs trames munies chacune d'un code détecteur d'erreur, par exemple d'un mot de code de type CRC.

De manière avantageuse, pour produire les k bits de redondance associés à $n_2$- k bits d'information, on utilise une matrice de Hamming à $n_2$ colonnes et k lignes dont tous les vecteurs colonne sont de parité impaire.

Le code de Hamming ne permet pas de corriger toutes les erreurs, à la différence du code de Reed-Salomon généralement utilisé. Il présente cependant sur ce dernier l'avantage d'un décodage plus simple, ce qui est important si ce décodage doit être fait en temps réel.

La matrice de Hamming est choisie en fonction des erreurs que l'on souhaite pouvoir corriger.

Pour la correction des erreurs longues sur un signal monodimensionnel, on choisit une matrice de Hamming dont toute suite de k vecteurs colonne consécutifs forme un système linéairement indépendant.

Pour la correction des erreurs périodiques sur un signal monodimensionnel, ce qui correspond à des erreurs longues affectant une piste parmi P lorsque le signal est enregistré sur un rapport à P pistes en parallèle où 1/p est la fréquence des erreurs dans le signal monodimensionnel, on choisit une matrice de Hamming dont toute suite de vecteurs colonne d'indice i, i + P, i + 2P, ..., i + (k-1)P, où i est un entier , forme un système linéairement indépendant.

Les caractéristiques et avantages de l'invention ressortiront mieux de la description qui va suivre, donnée à titre illustratif mais non limitatif, en référence aux dessins annexés, sur lesquels :

- la figure 1 illustre le format d'un bloc d'émission obtenu selon le procédé de transmission de l'invention,

- la figure 2 représente un mode de réalisation d'un dispositif de codage pour la mise en oeuvre du procédé de l'invention,
- les figures 3 et 4 illustrent deux modes de rangement des groupes d'un bloc sur un support d'enregistrement à 4 pistes,
- la figure 5 illustre un mode de réalisation de l'étage de reconnaissance des trames valides du dispositif de décodage mettant en oeuvre le procédé de l'invention,
- la figure 6 illustre un mode de réalisation de l'étage de calcul du syndrome du dispositif de décodage associé au procédé de l'invention, et
- la figure 7 illustre un mode de réalisation de l'étage de correction d'erreur du dispositif de décodage associé au procédé de l'invention.

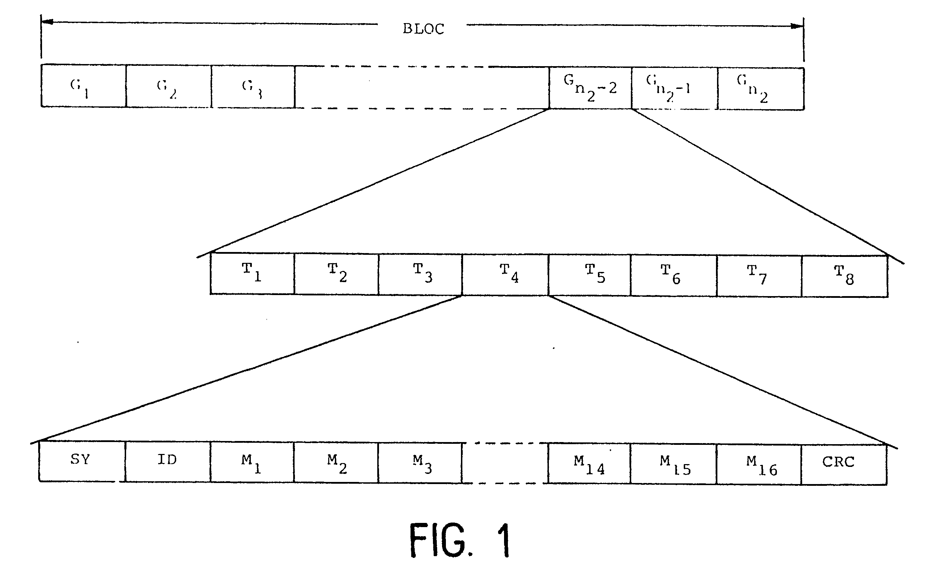

On va tout d'abord décrire en référence à la figure 1 la structure d'un bloc d'émission produit au moyen du procédé de l'invention.

Un bloc constitue une entité indépendante. Il se compose d'une suite de $n_2$ groupes $G_1$, $G_2$, .... $G_{n2}$. Chaque groupe contient un nombre déterminé de mots qui sont soit des mots d'information, soit des mots de redondance. Pour diminuer les risques d'erreurs, ces groupes sont organisés en trames. A titre d'exemple, dans la représentation de la figure 1, chaque groupe est constitué d'une suite de 8 trames $T_1$, $T_2$, ... $T_8$, chaque trame comprenant un mot de synchronisation SY, un mot d'identification ID notant le numéro de la trame dans le groupe et le numéro du groupe dans le bloc, une suite de 16 mots $M_1$, $M_2$, ... $M_{16}$ et un mot de code détecteur d'erreur. Ce mot d'identification peut éventuellement être étendu pour porter diverses informations associées aux mots $M_1$ à $M_{16}$ de la trame, tel qu'un facteur d'échelle.

Ce bloc contient 8 ensembles liés formés chacun d'une suite de $n_2$-k trames de 16 mots d'information et de k trames de 16 mots de redondance. Les éléments (bit, mot ou trame) d'un ensemble lié sont répartis à raison d'un élément par groupe, ces éléments occupant des positions homologues dans chaque groupe. Les $n_2$-k premiers groupes contiennent par exemple les $n_2$- k mots d'information de chaque ensemble lié et les k derniers groupes les mots de redondance associés.

Le nombre de mots par trame, de trames par groupe et de groupes par bloc sont fonction du canal de transmission ou du support d'enregistrement utilisé. Dans le cas où la transmission s'effectue par paquets, il peut être avantageux de faire correspondre trame et paquet. Dans le cas de l'enregistrement sur une bande magnétique, deux types principaux d'erreurs peuvent se produire : des erreurs longues dues à de gros incidents mécaniques affectant la bande magnétique sur une longueur d'environ 5 à 10 mm, et des erreurs courtes dues à une poussière ou un défaut magnétique affectant la bande sur une longueur de l'ordre du dixième de millimètre.

De préférence, chaque trame a une longueur de l'ordre du dixième de millimètre pour éviter de perdre un groupe complet lorsqu'il y a une erreur courte. Le nombre de trames par groupe dépend des capacités de correction souhaitées. Par exemple, pour $n_2$ = 16, on a k = 5 (code de Hamming étendu (16, 11)) et on peut corriger des erreurs longues s'étendant sur 5 groupes consécutifs, comme on le verra dans la suite de la description. Dans ce cas, chaque groupe doit avoir une longueur de 1 à 2 mm, ce qui représente une dizaine de trames par groupe.

Comme il est décrit dans la demande de brevet français n° 2 467 510 déjà citée, il est avantageux, dans le cas de l'enregistrement de mots d'information correspondant à un signal sonore, de séparer géographiquement les mots d'information pairs et les mots d'information impairs. Ceci peut être réalisé dans le cadre du procédé de l'invention en plaçant les trames de redondance en milieu de bloc, entre trames de mots d'information pairs et les trames de mots d'informations impairs.

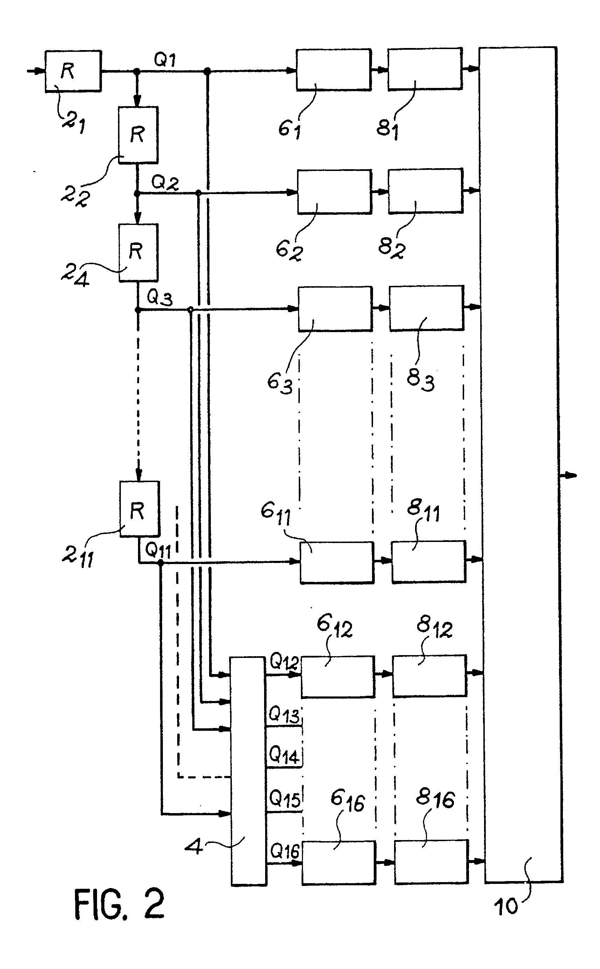

On a représenté sur la figure 2 un mode de réalisation d'un dispositif de transmission pour la mise en oeuvre du procédé de l'invention. Ce dispositif utilise un code de Hamming étendu (16, 11) pour associer 5 mots de redondance à chaque suite de 11 mots d'information.

Ce dispositif comprend un ensemble de 11 registres à décalage $2_1$, $2_2$, ... $2_{11}$ de N bits connectés en série, un circuit de codage 4 à 11 entrées reliées chacune à une sortie d'un registre à décalage $2_1$, $2_2$,..., $2_{11}$ et à 5 sorties, un ensemble de 16 registres du type premier entré-premier sorti $6_1$, $6_2$, ... $6_{16}$, les 11 premiers étant reliés en entrée chacun à l'un des registres à décalage $2_1$,-$2_{11}$ et les 5 autres étant reliés en entrée chacun à l'une des 5 sorties du circuit de codage, un ensemble de 16 moyens de mise en trame $8_1$, $8_2$, ... $8_{16}$ reliés chacun à l'un des registres $6_1$, $6_2$, ... $6_{16}$ et un moyen de multiplexage et de brassage 10.

Le dispositif reçoit des suites de $11 \times N$ bits sur l'entrée du registre à décalage $2_1$. Ces $11 \times N$ bits chargent les registres à décalage $2_1$, $2_2$, ... $2_{11}$ de N bits chacun. De préférence, N est un multiple de la longueur $n_1$ des mots d'informations. Ainsi, chaque registre contient, à la fin du chargement, un nombre entier de mots. Par exemple, on a N = 256 et $n_1$ = 16.

Après l'opération de chargement, 11 bits sont disponibles en parallèle, un à la sortie de chaque registre $2_1$, $2_2$, ... $2_{11}$. Ces 11 bits sont des bits homologues, i.e. de même rang, de 11 mots d'information différents.

Le circuit de codage 4 réalise, au moyen d'un ensemble de portes OU-EXCLUSIF, le calcul des 5 bits de redondance associés par codage de Hamming à ces 11 bits d'information. Ces 5 bits de redondance et ces 11 bits d'information forment un ensemble de 16 bits liés qui sont stockés, à raison d'un bit par registre, dans les registres $6_1$, $6_2$, ... $6_{16}$.

Le codage de Hamming des 11 bits d'information est représenté par une matrice de Hamming à 16 colonnes et 5 lignes. Cette matrice est choisie en fonction du format de transmission ou d'enregistrement des blocs. En choisissant une matrice dont les vecteurs colonnes sont de parité impaire, on est certain que tout triplet de vecteurs colonne forme un système linéairement indépendant. Ceci permet de corriger dans tous les cas au moins trois erreurs, si les codes détecteur d'erreur des trames ont détecté trois trames erronées.

Dans le cas où les codes détecteur d'erreur des trames ont détecté toutes les trames erronées, la matrice peut être optimisée pour corriger jusqu'à 5 erreurs portant sur des éléments liés consécutifs (jusqu'à k dans le cas général, où k est le nombre de mots de redondance).

Les vecteurs colonne de la matrice peuvent également être choisis en fonction du format d'enregistrement du bloc sur le support d'enregistrement ou du format de transmission du bloc dans le canal de transmission. Par exemple, dans le cas de l'enregistrement d'un bloc sur une bande magnétique comportant P pistes en parallèle, il est avantageux de choisir les vecteurs colonne tels que les vecteurs d'indice i, i + P, i + 2P, ... forment un système linéairement indépendant (ou 1 i P). Ceci permet d'assurer la correction d'une piste parmi P, pour P suffisamment grand.

Dans le cas du code de Hamming étendu (16, 11), choisi à titre d'exemple, on peut prendre la matrice de Hamming suivante :

$$H = \begin{bmatrix} 1 & 1 & 0 & 1 & 0 & 1 & 1 & 1 & 0 & 1 & 0 & 1 & 0 & 0 & 0 & 0 \\ 1 & 0 & 1 & 1 & 1 & 0 & 1 & 1 & 0 & 0 & 1 & 0 & 1 & 0 & 0 & 0 \\ 1 & 1 & 1 & 1 & 0 & 0 & 0 & 0 & 1 & 1 & 1 & 0 & 0 & 1 & 0 & 0 \\ 1 & 0 & 1 & 0 & 1 & 1 & 1 & 0 & 1 & 1 & 0 & 0 & 0 & 0 & 1 & 0 \\ 1 & 1 & 0 & 0 & 1 & 1 & 0 & 1 & 1 & 0 & 1 & 0 & 0 & 0 & 0 & 1 \end{bmatrix}$$

Cette matrice est telle que :
- tout triplet de vecteurs colonne forme un système linéairement indépendant ; il est possible de corriger tout triplet de trames reconnues erronées par les codes détecteur d'erreur de chaque trame,
- tout quintuplet de vecteurs colonne consécutifs forme un système linéairement indépendant ; il est possible de corriger la perte de 5 trames liées consécutives reconnues erronées par les codes détecteur d'erreur de chaque trame,
- les vecteurs colonne de rang (1, 5, 9, 13), (2, 6, 10, 14), (3, 7, 11, 15) ou (4, 8, 12, 16) forment des systèmes linéairement indépendants ; il est possible de corriger la perte d'une piste parmi 4 si les trames liées consécutives d'un bloc sont enregistrées de manière cyclique sur 4 pistes magnétiques.

Revenant sur la figure 2, l'opération de codage est répétée N fois pour chacun des N ensembles de 11 bits contenus en parallèle dans les registres à décalage $2_1$, $2_2$, ... $2_{11}$. Les registres $6_1$, $6_2$, ... $6_{16}$ contiennent alors chacun N bits.

Chaque ensemble de N bits est transmis à un moyen de mise en trame qui délivre au moyen 10 une trame contenant un mot de synchronisation, un mot d'identification de trame, N bits d'information ou de redondance et un code détecteur d'erreur, par exemple un mot de code de type CRC.

L'ensemble des 16 trames délivrées par les moyens de mise en trame constitue un ensemble lié. Le moyen de multiplexage et de brassage 10 peut former un bloc d'émission en multiplexant simplement ces trames. Le bloc comprend alors un seul ensemble lié et chacun des 16 groupes du bloc contient une seule trame.

De préférence, le moyen 10 est doté de moyens de mémorisation pour stocker plusieurs ensembles liés et de moyens de brassage ou d'entrelacement pour entrelacer les trames des ensembles liés afin de délivrer un bloc dont chaque groupe comprend plusieurs trames. Cet entrelacement a pour but de séparer géographiquement les trames d'un même ensemble lié de manière à limiter la probabilité de perdre plusieurs trames d'un même ensemble lié. Ces méthodes d'entrelacement sont bien connues de l'homme de l'art.

Le bloc produit par le dispositif de la figure 2 et dont la structure a été décrite en référence à la figure 1 est transmis sur un canal de transmission ou enregistré sur un support d'enregistrement. Le support d'enregistrement peut comprendre une ou plusieurs pistes en parallèle.

Dans le cas où le support d'enregistrement comprend une seule piste, il est analogue à un canal de transmission. Le bloc est enregistré linéairement suivant le format de la figure 1.

Dans le cas où le support d'enregistrement est une bande magnétique, il comprend en général plusieurs pistes en parallèle. Chaque ensemble lié du bloc est alors de préférence réparti sur plusieurs pistes de la bande magnétique.

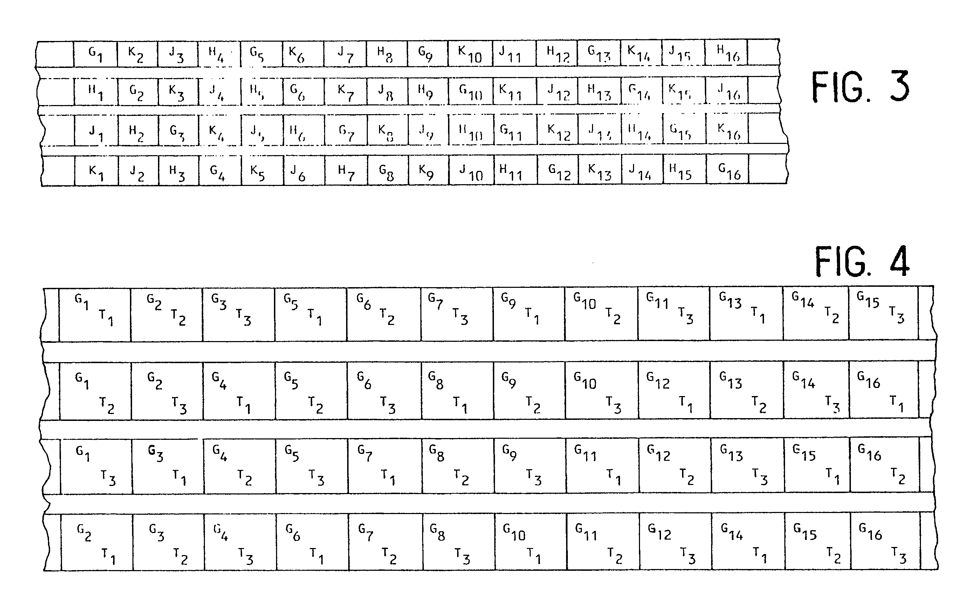

On a représenté sur la figure 3 un format d'enregistrement de 4 blocs G, H, J, K comportant respectivement les groupes $G_1$ à $G_{16}$, $H_1$ à $H_{16}$, $J_1$ à $J_{16}$ et $K_1$ à $K_{16}$. Les groupes successifs d'un même bloc sont disposés séquentiellement dans le sens longitudinal de la bande et avec un décalage cyclique d'une piste dans le sens transversal de la bande.

Ainsi, pour chaque ensemble lié, composé de 11 mots d'information et de 5 mots de redondance répartis dans les 16 groupes d'un bloc, 4 mots apparaissent sur chaque piste. Ces mots sont liés à des vecteurs colonnes indépendants si le codage de chaque bloc est obtenu avec la matrice H indiquée plus haut. Dans ce cas, les 4 mots d'un ensemble lié enregistrés sur la même piste peuvent être perdus simultanément sans dépasser la capacité de correction d'erreur, c'est-à-dire que ces 4 mots peuvent être corrigés par les 12 mots de l'ensemble lié répartis sur les 3 autres pistes.

Les blocs G, H, J et K étant indépendants, le codage de l'invention permet de corriger une piste dont toutes les informations ont été perdues. L'ensemble des 4 blocs G, H, J, K a des limites définies sur le support d'enregistrement. Cet ensemble constitue lui-même un bloc. La structure en blocs consécutifs indépendants sur le support d'enregistrement est donc préservée, ce qui permet de faire facilement du montage électronique.

La propriété de correction est liée au fait que les mots d'un ensemble lié qui sont enregistrés sur une même piste sont associés à des vecteurs linéairement indépendants de la matrice de Hamming. Cette propriété peut être obtenue de différentes façons.

A titre d'exemple, une autre possibilité consiste à utiliser un bloc unique dont chaque groupe est scindé en un nombre de trames p premier avec le nombre de pistes de la bande magnétique et en enregistrant les trames successives selon la direction transversale de la bande.

Un tel format est représenté sur la figure 4 pour un bloc de 16 groupes $G_1$ à $G_{16}$ comprenant chacun trois trames $T_1$, $T_2$ et $T_3$ enregistrées sur une bande magnétique à 4 pistes. Les 16 mots formant un ensemble lié sont répartis dans les 16 groupes à raison d'un mot par groupe ; chaque mot occupant une position homologue dans chaque groupe est contenu dans une trame de même indice. Avec la matrice H choisie, en particulier, les vecteurs colonne de rang (1, 5, 9, 13) sont linéairement indépendants. Ceci permet de corriger notamment les trames $G_1T_1$, $G_5T_1$, $G_9T_1$ et $G_{13}T_1$ à partir des trames $T_1$ des autres groupes. Plus précisément, la matrice choisie et le format d'enregistrement de la figure 4 permettent de corriger complètement l'information d'une piste à partir des trois autres pistes.

On va maintenant décrire une stratégie de détection et de correction des erreurs à la lecture d'un bloc. Cette restitution des mots d'information transmis ou enregistrés se fait en trois étapes :
- une étape de reconnaissance de trames valides ; ceci est réalisé principalement par le code détecteur d'erreur,
- une étape de calcul des syndromes associés à chaque ensemble de $n_2- k$ bits liés, chaque bit occupant une position homologue dans $n_2-k$ trames différentes,
- une étape de détection des erreurs non détectées par les codes détecteur d'erreur et de correction des mots d'information en fonction du résultat des syndromes.

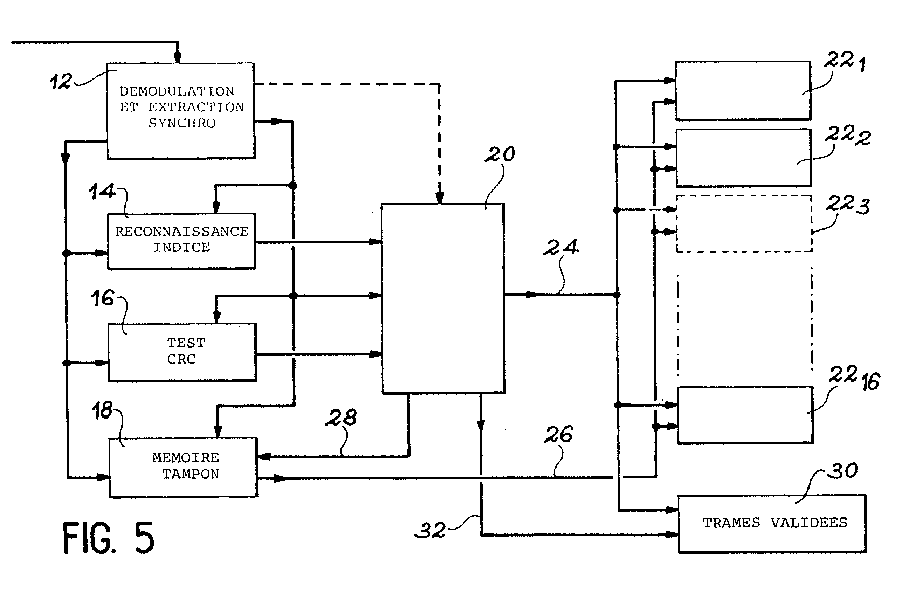

Ces trois étapes sont mises en oeuvre dans trois circuits constituant un dispositif de décodage. Un mode de réalisation de chacun de ces circuits est représenté sur les figures 5 à 7. Pour une meilleure compréhension de l'invention, on va décrire d'abord le procédé de l'invention en considérant successivement les différents cas d'erreurs possibles. Cette description est faite pour un codage de Hamming étendu (16, 11) défini par la matrice H dont on rappelle la valeur :

$$H = \begin{bmatrix} 1 & 1 & 0 & 1 & 0 & 1 & 1 & 1 & 0 & 1 & 0 & 1 & 0 & 0 & 0 & 0 \\ 1 & 0 & 1 & 1 & 1 & 0 & 1 & 1 & 0 & 0 & 1 & 0 & 1 & 0 & 0 & 0 \\ 1 & 1 & 1 & 1 & 0 & 0 & 0 & 0 & 1 & 1 & 1 & 0 & 0 & 1 & 0 & 0 \\ 1 & 0 & 1 & 0 & 1 & 1 & 1 & 0 & 1 & 1 & 0 & 0 & 0 & 0 & 1 & 0 \\ 1 & 1 & 0 & 0 & 1 & 1 & 0 & 1 & 1 & 0 & 1 & 0 & 0 & 0 & 0 & 1 \end{bmatrix}$$

Le procédé de décodage de l'invention permet au moins de corriger les erreurs suivantes :
- 3 erreurs sur 3 bits quelconques d'un ensemble de bits liés reconnus invalides par les codes détecteur d'erreur de chaque trame,
- 5 erreurs sur 5 bits liés consécutifs (i.e. associés à 5 vecteurs colonne consécutifs de la matrice H) d'un ensemble de bits liés reconnus invalides par les codes détecteur d'erreur de chaque trame,
- une erreur sur un bit d'un ensemble lié, lorsqu'aucun bit de l'ensemble n'a été invalidé par les codes détecteur d'erreur,
- une erreur sur un bit d'un ensemble lié, lorsqu'un seul autre bit de cet ensemble a été invalidé par un code détecteur d'erreur.

Ce procédé permet également, avec la matrice H choisie, de corriger un nombre important de configurations dans lesquelles 4 ou 5 bits quelconques (consécutifs ou non) d'un ensemble lié ont été invalidés par les codes détecteur d'erreur. Les taux de configurations d'erreurs corrigibles sont respectivement de 93 % et de 66 % des cas pour 4 et 5 erreurs.

On note $a_1$, $a_2$, ... $a_{11}$ les bits liés ou bits homologues de mots d'information d'un ensemble lié. Supposons que les valeurs transmises $a_3$, $a_4$, $a_5$, $a_6$ et $a_7$ n'ont pas été validées par les codesdétecteur d'erreur de trame, c'est-à-dire qu'elles sont susceptibles d'être erronées, et notons $a'_3$, $a'_4$, $a'_5$, $a'_6$ et $a'_7$ les valeurs reçues et $(e_3, e_4, e_5, e_6, e_7)$ le vecteur d'erreur.

On a :

$$\begin{pmatrix} a'_3 \\ a'_4 \\ a'_5 \\ a'_6 \\ a'_7 \end{pmatrix} = \begin{pmatrix} a_3 \\ a_4 \\ a_5 \\ a_6 \\ a_7 \end{pmatrix} + \begin{pmatrix} e_3 \\ e_4 \\ e_5 \\ e_6 \\ e_7 \end{pmatrix}$$

Considérons la matrice H' formée des vecteurs colonne de rang 3, 4, 5, 6 et 7 de la matrice H :

$$H' = \begin{pmatrix} 01011 \\ 11101 \\ 11000 \\ 10111 \\ 00110 \end{pmatrix}$$

On a la relation :

$$H' \cdot \begin{pmatrix} e_3 \\ e_4 \\ e_5 \\ e_6 \\ e_7 \end{pmatrix} = \begin{pmatrix} s_1 \\ s_2 \\ s_3 \\ s_4 \\ s_5 \end{pmatrix}$$

où $(s_1, s_2, s_3, s_4, s_5)$ est le syndrome défini par

$$H \cdot \begin{pmatrix} a'_1 \\ a'_2 \\ a'_3 \\ a'_4 \\ \vdots \\ a'_{16} \end{pmatrix} = \begin{pmatrix} s_1 \\ s'_2 \\ s_3 \\ s'_4 \\ s_5 \end{pmatrix}$$

On en déduit :

$$\begin{pmatrix} a_3 \\ a_4 \\ a_5 \\ a_6 \\ a_7 \end{pmatrix} = \begin{pmatrix} a'_3 \\ a'_4 \\ a'_5 \\ a'_6 \\ a'_7 \end{pmatrix} + (H')^{-1} \cdot \begin{pmatrix} s_1 \\ s_2 \\ s_3 \\ s_4 \\ s_5 \end{pmatrix}$$

La correction du vecteur reçu $(a'_3, a'_4, a'_5, a'_6, a'_7)$ pour obtenir le vecteur transmis $(a_3, a_4, a_5, a_6, a_7)$ se ramène donc au calcul de l'inverse de la matrice H'. Cette matrice inverse n'existe que si les vecteurs colonne de H sont linéairement indépendants . Dans l'exemple choisi, la matrice H' est inversible et on a :

$$H'^{-1} = \begin{pmatrix} 11001 \\ 11101 \\ 10110 \\ 10111 \\ 11010 \end{pmatrix}$$

Il est donc possible de corriger les 5 erreurs détectées contenues dans le vecteur reçu. La capacité de correction s'arrête là ; il n'est pas possible de corriger des erreurs non détectées par les codes détecteur d'erreur de trame.

Lorsque la matrice H' n'est pas inversible, les bits manquants peuvent être estimés par des techniques de masquage connues telles que par interpolation entre des mots d'information consécutifs.

Dans le cas où 4 bits d'un ensemble lié n'ont pas été validés par les codes détecteur d'erreur de trame, la correction s'effectue sensiblement de la même manière que dans le cas précédent.

Supposons que les bits de rang 8, 9, 10 et 11 sont invalidés. On considère la matrice H' composée des colonnes de rang 8, 9, 10 et 11 de la matrice H, soit :

$$H' = \begin{pmatrix} 1010 \\ 1001 \\ 0111 \\ 0110 \\ 1101 \end{pmatrix}$$

et on a :

$$H' \cdot \begin{pmatrix} e_8 \\ e_9 \\ e_{10} \\ e_{11} \end{pmatrix} = \begin{pmatrix} s_1 \\ s_2 \\ s_3 \\ s_4 \\ s_5 \end{pmatrix}$$

On cherche H" telle que:

$$\begin{pmatrix} 1000 \\ 0100 \\ 0010 \\ 0001 \\ 0000 \end{pmatrix} \cdot \begin{pmatrix} e_8 \\ e_9 \\ e_{10} \\ e_{11} \end{pmatrix} = H'' \cdot \begin{pmatrix} 1 \\ 2 \\ 3 \\ 4 \\ 5 \end{pmatrix}$$

Le calcul donne :

$$H'' = \begin{pmatrix} 01110 \\ 11100 \\ 11110 \\ 00110 \\ 10101 \end{pmatrix}$$

La dernière équation du système, soit $0 = s_1 + s_3 + s_5$ est une équation de compatibilité. Lorsque cette équation de compatibilité n'est pas vérifiée, c'est que les codes détecteur d'erreur de trame n'ont pas détecté toutes les erreurs. Dans ce cas, il n'est pas possible de corriger les mots reçus. Les bits erronés peuvent alors être estimés par des techniques de masquage.

Ces techniques de masquage sont également utilisées lorsque la matrice H" n'existe pas.

Les cas où 3, 2 ou 1 bits d'un ensemble lié sont invalidés se traitent de la même manière que le cas où 4 bits d'un ensemble lié sont invalidés, la seule différence étant que pour 3 bits, 2 bits ou 1 bit, il y a respectivement 2, 3 et 4 équations de compatibilité qui doivent être satisfaites.

Le procédé de l'invention permet également de corriger une erreur non détectée par les codes détecteur d'erreur dans un ensemble de bits liés, lorsqu'aucune erreur n'a été détectée par ces codes détecteur d'erreur de trame. Cette situation s'avère lorsque tous les bits d'un ensemble lié sont validés et que le syndrome associé n'est pas nul.

La localisation de l'erreur dans les bits de l'ensemble lié est déterminée par la valeur du syndrome. Si l'erreur non détectée est unique, ce qui est le cas le plus probable, le syndrome est égal au vecteur colonne de la matrice H dont le rang est le même que celui du bit erroné.

Le procédé de l'invention permet enfin de corriger une erreur non détectée par les codes détecteur d'erreur de trame alors qu'un bit de l'ensemble de bits liés a été invalidé.

Deux cas se présentent selon que le bit non validé est juste ou faux. Ces cas sont distingués par la parité du syndrome. Si le nombre de bits à "1" du syndrome est impair, le bit non validé est juste et le syndrome est égal au vecteur colonne de la matrice H dont le rang est identique à celui du bit erroné non détecté. Si le nombre de bits à "1" du syndrome est pair, le bit non validé est faux et le syndrome est égal à la somme des vecteurs colonne associés au bit non validé et au bit erroné non détecté. Par exemple, si le syndrome est (1, 1, 0, 0, 0) et si le bit de rang 2 est non validé et erroné, le vecteur colonne de la matrice H associé au bit erroné non détecté est

$$\begin{pmatrix} 1 \\ 1 \\ 0 \\ 0 \\ 0 \end{pmatrix} + \begin{pmatrix} 1 \\ 0 \\ 1 \\ 0 \\ 1 \end{pmatrix} = \begin{pmatrix} 0 \\ 1 \\ 1 \\ 0 \\ 1 \end{pmatrix}$$

Le bit erroné non détecté est donc celui de rang 11.

On va maintenant décrire un mode de réalisation du dispositif de décodage mettant en oeuvre le procédé de décodage de l'invention. Ce dispositif comprend trois circuits représentés respectivement sur les figures 5 à 7.

Le circuit de la figure 5 est un circuit de reconnaissance des trames valides dans les trames reçues. Ce circuit a une structure classique.

Il comprend en entrée un moyen de démodulation et d'extraction de synchronisation 12 recevant successivement les différentes trames d'un bloc. L'opération de démodulation permet de détecter le mot de synchronisation de trame dans le cas où celui-ci est transmis par violation de code. Une telle technique est particulièrement intéressante dans le cas d'une longue interruption du signal reçu, comme c'est le cas lorsqu'un défaut affecte une bande magnétique, car elle permet une resynchronisation très rapide du moyen 12 sur les trames reçues.

Le moyen 12 délivre le mot d'identification de trame à un moyen de reconnaissance d'indice 14, les informations nécessaires à la détection d'erreurs de trame à un moyen de test 16 et les N bits des mots d'information ou de redondance à un tampon 18. L'entrée des données dans les moyens 14, 16 et dans le tampon 18 est rythmé par des signaux d'horloge produits de manière connue par le moyen 12.

Les bits d'information utile de la trame sont validés par un moyen de validation 20 si le mot d'identification est reconnu par le moyen 14 et si le code détecteur d'erreur indique l'absence d'erreurs. Le moyen de validation peut en outre décider de l'invalidation d'une trame en fonction d'autres informations qui peuvent être communiquées par le moyen 12 telles qu'une longueur de trame anormale ou une violation de code pour les bits d'information utile.

Dans ce circuit, la trame est considérée comme une entité indivisible en ce qui concerne sa validité. Si le code détecteur d'erreur d'une trame détecte une erreur, la trame est considérée invalide et tous les bits de cette trame sont marqués.

Selon une variante de réalisation, le code détecteur d'erreur invalide uniquement les bits de la trame considérés comme erronés. Le traitement de détection et de correction des erreurs au moyen des mots de redondance est alors un traitement bit à bit, c'est-à-dire que ce traitement afTecte des ensembles de $n_2$ bits, dont $n_2$-k d'information et k de redondance, extraits de $n_2$ trames liées, et que ce traitement est répété pour chaque ensemble de $n_2$ bits qui occupe un rang donné dans lesdites trames.

On a indiqué précédemment que ce traitement comporte notamment une étape d'inversion de matrice. On comprend que le traitement bit à bit d'une trame peut être long. Il est donc en général préférable de valider ou d'invalider simultanément tous les bits de la trame. Ainsi, une même matrice est utilisée pour chaque ensemble de $n_2$ bits ; il n'y a dans ce cas qu'un seul calcul de matrice inverse par ensemble de trames liées.Il en résulte une vitesse de traitement beaucoup plus importante. De plus, il faut noter que ce traitement par trames est tout à fait adapté à la probabilité d'erreur sur le support d'enregistrement puisque, ainsi qu'on l'a indiqué précédemment, la longueur d'une trame est choisie du même ordre de grandeur que les erreurs courtes (environ 1/10 de millimètre) sur le support d'enregistrement.

Revenons maintenant à la figure 5. Lorsqu'une trame est validée, elle est mémorisée dans l'une des 16 mémoires $22_1$, $22_2$, ... $22_{16}$. Ces mémoires sont représentées distinctes pour une meilleure compréhension. En pratique, ce sont des zones d 'une même mémoire de travail. Ces mémoires sont adressées par un bus d'adresses 24 par le moyen de validation 20. Une ligne de donnée 26 relie la sortie de donnée du tampon 18 aux entrées des mémoires $22_1$ à $22_{16}$ ; l'émission de données en série sur cette ligne de données est commandée par une connexion 28 reliant le moyen de validation 20 au tampon 18. L'adressage des mémoires $22_1$ à $22_{16}$ est fait de manière à mémoriser les trames liées dans le même ordre que dans les moyens de mise en trame du dispositif de transmission de la figure 2.

Le circuit de la figure 5 comprend enfin un registre 30 relié au bus d'adresse 24. Ce registre est vidé avant la réception d'un bloc par le circuit. Ceci est réalisé par le moyen de validation 20 par un signal de commande émis sur une connexion 32. Ensuite, pour chaque trame reçue, le moyen de validation 20 émet vers ledit registre 30 une donnée pour marquer les trames valides reçues.

Le contenu des mémoires associées aux trames non valides est indifférent pour la correction tant que les capacités de correction ne sont pas dépassées. Au-delà, la stratégie de chargement des mémoires est liée aux méthodes de masquage éventuellement appliquées à l'information transmise. Dans le cas de transmission par paquet, un paquet erroné ou perdu sera considéré indifféremment comme une trame invalide.

Le circuit représenté sur la figure 5 correspond au cas où le signal reçu provient d'un seul canal de transmission ou d'un support d'enregistrement à une seule piste. Dans le cas par exemple d'un support d'enregistrement à plusieurs pistes, il faut prévoir pour chaque piste un ensemble constitué des moyens 12, 14, 16, 18 et 20.

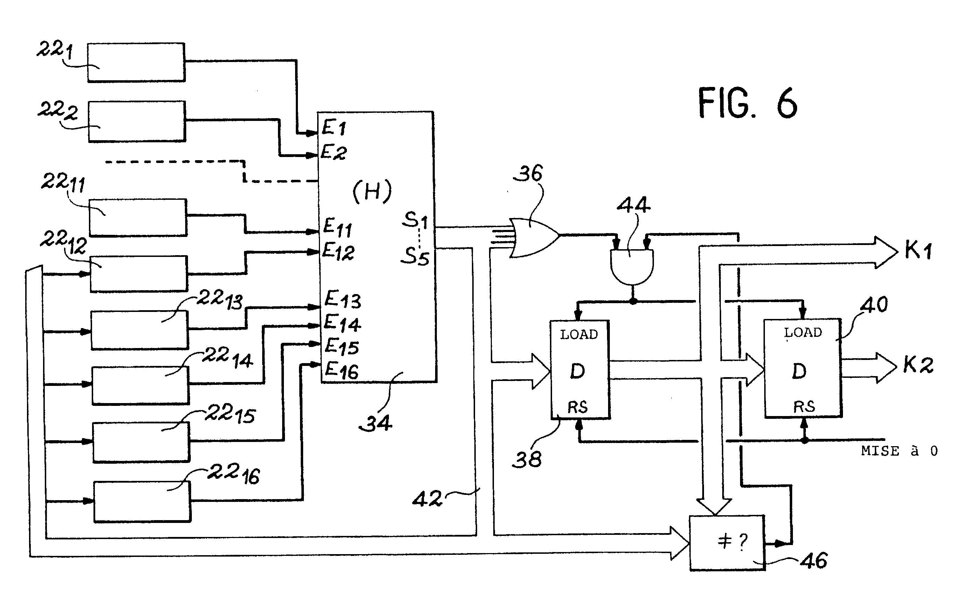

Les mémoires $22_1$ à $22_{16}$ sont accédées en écriture par le circuit de reconnaissance de trames de la figure 5. Elles sont également accédées en lecture par le circuit de calcul du syndrome de la figure 6. Plusieurs solutions connues existent pour réaliser ce double accès. Une première solution consiste à prévoir deux jeux de mémoires $22_1$ à $22_{16}$ et deux registres 30, un jeu étant accessible en lecture et l'autre en écriture pendant la réception d'un bloc, le rôle des deux jeux étant permuté après chaque bloc. Une autre solution est d'utiliser des mémoires à plusieurs ports organisées en pages, chaque page étant affectée aux trames d'un bloc. Cette solution permet également d'assurer la fonction de désentrelacement lorsque les trames liées sont entrelacées avec d'autres trames, comme c'est le cas dans le format de la figure 1.

Le circuit représenté sur la figure 6 calcule les syndromes associés aux ensembles de 16 bits liés reçus. Il compare ces syndromes à zéro et est apte à mémoriser deux syndromes non nuls différents.

La possibilité de mémoriser deux syndromes différents ne couvre pas tous les cas. Cette valeur particulière de deux syndromes mémorisables est choisie ici car elle est suffisante pour détecter une erreur non détectée par les codes détecteur d'erreur de trame et car la probabilité d'avoir deux erreurs non détectées par les codes détecteur d'erreur est très improbable.

Sur le circuit de la figure 6, on a reproduit les mémoires $22_1$ à $22_{16}$ dont l'accès est partagé avec le circuit de reconnaissance des trames valides de la figure 5. Chaque mémoire comprend une sortie de données unique qui est reliée à une entrée d'un moyen de calcul de syndrome 34 à 16 entrées $E_1$, $E_2$, ..., $E_{16}$. Ce moyen délivre sur 5 sorties $S_1$, $S_2$, $S_3$, $S_4$ et $S_5$ le syndrome défini par le produit entre la matrice de Hamming H et le vecteur des 16 bits liés reçu.

Une porte OU 36 dont les entrées sont reliées aux sorties du moyen 34 permet de détecter si le syndrome est nul. Le circuit comprend également deux bascules de type D 38, 40 en série, chaque bascule contenant 5 bits, la bascule 38 étant reliée à la sortie du moyen 34 par un bus de données 42. Les deux bascules sont chargées simultanément par le signal de sortie d'une porte ET 44 dont une entrée est reliée à la sortie de la porte OU 36 et dont l'autre entrée est reliée à la sortie d'un moyen de comparaison 46 qui délivre un signal au niveau haut lorsque les syndromes délivrés par le moyen 34 et la bascule 38 sont différents.

Cet ensemble, dans lequel les bascules sont initialisées à zéro en début de bloc, permet de mémoriser le premier syndrome non nul d'un bloc dans la bascule 38 et, lorsqu'un second syndrome non nul est détecté, de décaler le premier syndrome de la bascule 38 à la bascule 40 et de mémoriser le second syndrome dans la bascule 38. Si un troisième syndrome non nul est détecté, il y a un nouveau décalage du contenu des bascules 38 et 40 et le premier syndrome est perdu. De manière générale, les bascules 38 et 40 mémorisent les deux derniers syndromes non nuls d'une trame.

Tous les syndromes calculés, qu'ils soient nuls ou non nuls, sont réintroduits dans les mémoires $22_{12}$ à $22_{16}$ en remplacement des bits de redondance correspondants. Ceci est réalisé par l'intermédiaire du bus de données 42 dont chaque ligne de donnée est reliée à une entrée de donnée des mémoires $22_{12}$ à $22_{16}$

A la fin du calcul des syndromes d'un ensemble de mots liés, trois cas peuvent se présenter :
- tous les syndromes sont nuls ; les bascules 38 et 40 contiennent des valeurs nulles,
- un unique syndrome est non nul ; il est contenu dans la bascule 38,
- au moins deux syndrones différents sont non nuls ; deux d'entre eux sont contenus dans les bascules 38 et 40.

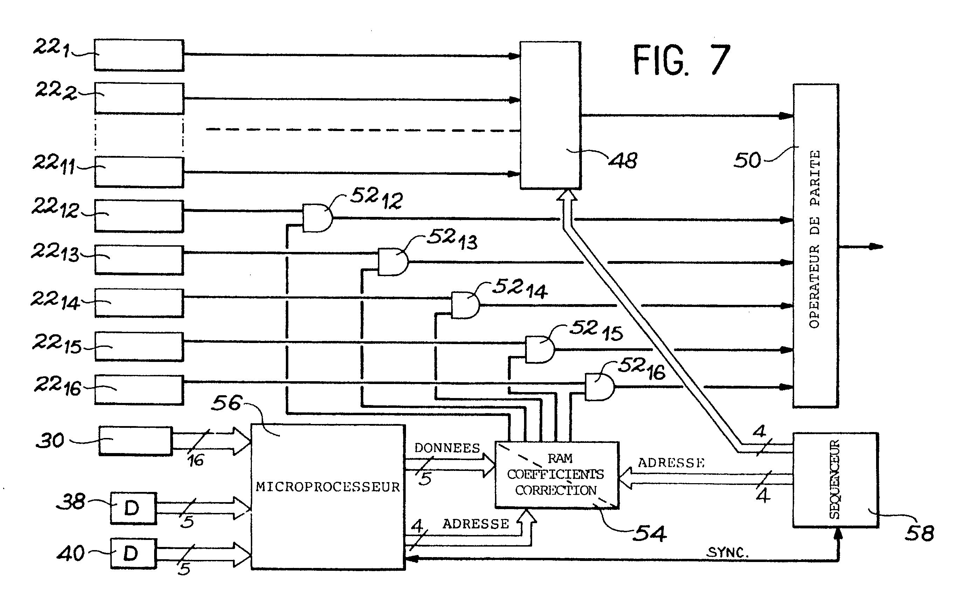

Ainsi qu'on l'a expliqué précédemment, la valeur du syndrome associé à un ensemble de bits liés et l'état de validité des trames contenant chacune un de ces bits liés permet de corriger l'ensemble de bits liés reçus pour retrouver l'ensemble de bits liés transmis. Cette correction est mise en oeuvre dans le circuit de correction dont un exemple de réalisation est donné sur la figure 7.

Sur cette figure, on a reproduit les mémoires $22_1$ à $22_{16}$, le registre 30 et les bascules 38 et 40 qui contiennent respectivement des ensembles de trames liées, des bits de validation de trame et, le cas échéant, des syndromes non nuls.

Le circuit représenté sur la figure 7 comprend un multiplexeur 48 dont les entrées sont reliées aux sorties des mémoires $22_1$ à $22_{11}$ contenant des bits d'information. La sortie de ce multiplexeur est reliée à une entrée d'un opérateur de parité 50 de type OU-EXCLUSIF. Pour chaque mémoire $22_{12}$ à $22_{16}$ contenant les bits du syndrome, la sortie de données est reliée à l'entrée d'une porte ET $52_{12}$ à $52_{16}$ dont la sortie est appliquée sur une entrée de l'opérateur de parité 50. La deuxième entrée de chaque porte ET est alimentée par un bit d'un masque de 5 bits contenu dans une mémoire vive (RAM) 54.

Le circuit comprend également un moyen de calcul, tel qu'un microprocesseur 56, pour calculer ce masque en fonction du contenu du registre 30 et des bascules 38 et 40. Le microprocesseur 56 est synchronisé avec un séquenceur 58 qui assure la sélection des données en entrée du multiplexeur 48 et dans la mémoire vive 54.

Le traitement effectué par le microprocesseur 56 porte sur un ensemble complet de trames liées et comprend deux étapes successives : la recherche de trames erronées non détectées par les codes détecteur d'erreur de trame, et le calcul des coefficients de correction formant le masque appliqué sur les deuxièmes entrées des portes ET $52_{12}$ à $52_{16}$.

Dans une première étape, le microprocesseur lit le contenu du registre 30 pour déterminer le nombre de trames invalides détectées, c'est-à-dire le nombre de bits liés invalidés parmi les 16 bits d'un ensemble liés. Si ce nombre de trames invalides est supérieur à 5 (nombre de bits de redondance), la correction est impossible et les 11 bits d'information de l'ensemble de bits liés sont estimés par des techniques de masquage.

Dans le cas où le nombre de trames déclarées invalides par le registre 30 est égal à 0 ou 1, le microprocesseur examine les syndromes $K_1$ et $K_2$ contenus dans les bascules 38 et 40 pour détecter une éventuelle trame fausse qui n'aurait pas été invalidée par son code détecteur d'erreur.

L'observation des syndromes $K_1$ et $K_2$ permet de détecter, dans certains cas, deux trames fausses non invalidées par les codes détecteur d'erreur. Cette éventualité est très peu probable et n'est pas prise en compte ici.

Si aucune erreur n'a été détectée par les codes détecteur d'erreur, trois cas sont possibles :

a) les syndromes $K_1$ et $K_2$ sont nuls ; aucune trame n'est erronée, le microprocesseur 56 inscrit dans la mémoire RAM 54, pour chaque trame, un masque constitué de 5 "0". Ce masque est appliqué sur les entrées des portes ET $52_{12}$ à $52_{16}$ : l'opérateur de parité 50 est transparent pour les mots série délivrés par le multiplexeur 48.

b) le syndrome $K_1$ présente un nombre impair de "1" et le syndrome $K_2$ est nul. Il existe alors une trame invalide non détectée par son code détecteur d'erreur. Cette trame est celle qui est associée au vecteur colonne égal au syndrome $K_1$.

c) le syndrome $K_1$ présente un nombre pair de "1" ou le syndrome $K_2$ n'est pas nul. Il y a alors plus d'une trame invalide non détectée par les codes détecteur d'erreur ; la correction n'est pas entreprise (ce cas est très peu probable).

Considérons maintenant le cas où une erreur a été détectée par un code détecteur d'erreur. Quatre cas se présentent :

a) les syndromes $K_1$ et $K_2$ sont nuls. On considère alors que l'erreur détectée par le code détecteur d'erreur porte sur des bits de la trame autres que des bits liés, par exemple des bits du code détecteur d'erreur,

b) le syndrome $K_1$ comporte un nombre impair de "1" et le syndrome $K_2$ est nul. Si le syndrome $K_1$ correspond à la trame déjà détectée par le code détecteur d'erreur, i.e. si le syndrome $K_1$ est égal au vecteur colonne de la matrice de Hamming dont le rang est le même que celui de la trame invalide dans l'ensemble des trames liées, il n'y a pas d'erreur supplémentaire. En revanche, si le syndrome $K_1$ correspond une autre trame, on considère que cette autre trame est invalide,

c) les syndromes $K_1$ et $K_2$ sont non nuls.

c1) si les syndromes sont impairs, ils correspondent à deux trames invalides différentes. La correction n'est entreprise que si l'une de ces deux trames invalides est celle détectée par le code détecteur d'erreur,

c2) si les syndromes sont de parité différentes, le syndrome ayant un nombre impair de "1" résulte d'une erreur sur la trame associée, i.e. dont le rang correspond au vecteur colonne de la matrice égal au syndrome, et le syndrome ayant un nombre pair de "1" résulte d'une erreur sur deux trames différentes. La deuxiéme trame invalide est associée au vecteur colonne égal à $K_1 + K_2$. La correction n'est entreprise que si l'une des deux trames trouvées invalides par les syndromes $K_1$ et $K_2$ est égale à la trame détectée invalidée par le code détecteur d'erreur,

d) dans les autres cas, il y a plus d'une erreur non détectée par les codes détecteur d'erreur et la correction n'est pas entreprise. Il faut noter qu'il s'agit ici d'une stratégie particulière qui est liée au fait que la probabilité que deux erreurs n'ont pas été détectées par les codes détecteur d'erreur est très faible. Cependant, du seul point de vue mathématique, la correction reste possible, dans ce cas, dans un certain nombre de configurations d'erreurs.

L'observation des syndromes $K_1$ et $K_2$ permet donc de modifier, si nécessaire, le contenu du registre 30 contenant l'état de validité de chaque trame.

L'étape suivante consiste pour le microprocesseur 56, à former la matrice H' à c (c 5) colonnes et 5 lignes formées par les c vecteurs colonnes associés aux c trames invalidées classées par rang croissant. Cette matrice H' est transformée de manière classique, par exemple par triangulation, pour produire une matrice $H'^{-1}$ à 5 colonnes et 5 lignes.

Si cette opération n'est pas possible, ce qui peut se produire lorsqu'il y a 4 ou 5 erreurs, la correction n'est pas entreprise. Dans le cas où l'opération est possible, on obtient une relation reliant les erreurs des c trames erronées aux 5 trames de syndromes. Cette relation s'exprime, pour chaque trame, par un jeu de 5 coefficients binaires de correction qui constituent une ligne de la matrice $H'^{-1}$ ou H". Pour les trames validées, les coefficients de correction sont égaux à "0".

Le séquenceur 58 commande simultanément le multiplexeur 48 et la mémoire RAM 54 pour délivrer à l'opérateur de parité 50 un bit d'une trame et le mot de correction associé, ce mot étant égal au syndrome multiplié par le masque formé par les 5 coefficients binaires de correction.

**Revendications**

1. Procédé de transmission en blocs de mots d'information numériques ayant chacun une longueur de $n_1$ bits, où $n_1$ est un entier, ledit procédé consistant à ajouter successivement aux mots d'information à transmettre des mots d'un code correcteur d'erreur et des mots d'un code détecteur d'erreur ; procédé dans lequel :

   - le code correcteur d'erreur est un code de Hamming au moyen duquel on ajoute k mots de redondance à chaque suite de $n_2$-k ($n_2$>k) mots d'information consécutifs, lesdits $n_2$-k mots d'information formant avec les k mots de redondance un ensemble de mots appelé ensemble lié, chaque mot de redondance ayant $n_1$ bits et, pour chaque rang i, où $1 \leq i \leq n_1$, les k bits de rang i des mots de redondance sont des bits de redondance des $n_2$-k bits de rang i des $n_2$-k mots d'information, ledit codage étant réalisé par une matrice de Hamming dont les vecteurs colonne sont choisis de manière à permettre la correction d'un sous-ensemble déterminé des erreurs possibles,
   - le code détecteur d'erreur est appliqué à des suites de mots d'information ou à des suites de mots de redondance, les mots d'une même suite appartenant à des ensembles liés différents, chaque bloc transmis comprenant une pluralité de suites de $n_2 - k$ mots d'information et les mots de codes détecteur et correcteur d'erreur associés, caractérisé en ce que pour un signal enregistré sur un support à P pistes en parallèle, les k bits de redondance associés à $n_2-k$ bits d'information sont produits en utilisant une matrice de Hamming à $n_2$ colonnes et k lignes dont toute suite de k vecteurs d'indices $i, i+P, i+2P,..., i+(k-1)P$, où 1, P sont entiers et $i+(k-1)P \leq n_2$, forme un système linéairement indépendant, chaque ensemble lié d'un bloc étant réparti sur plusieurs pistes, un mot de code étant ainsi distribué sur plusieurs pistes tandis que plusieurs éléments dudit mot sont enregistrés sur la même piste.

2. Procédé selon la revendication 1, pour l'enregistrement d'un bloc sur un support d'information comprenant P pistes d'enregistrement en parallèle, caractérisé en ce qu'on répartit les $n_2$ mots d'un ensemble lié sur les P pistes tel que les mots enregistrés sur une même piste sont associés à des vecteurs colonne de la matrice de Hamming qui forment un système linéairement indépendant.

3. Procédé selon la revendication 1 ou 2, caractérisé en ce que, après avoir associé k mots de redondance à $n_2-k$ mots d'information pour former un ensemble de mots lié, on entrelace les mots de $n_3$ ensembles liés pour former un bloc d'émission composé de $n_2$ groupes, chaque groupe contenant un mot de chaque ensemble lié et au moins un code détecteur d'erreur.

4. Procédé selon la revendication 3, caractérisé en ce que les groupes contenant des mots de redondance sont placés en milieu de bloc, entre les groupes contenant les mots d'information pairs et les groupes contenant les mots d'information impairs.

5. Procédé selon l'une quelconque des revendications 1 à 4, caractérisé en ce que chaque mot d'un ensemble lié est contenu dans une trame, chaque trame comprenant un mot de synchronisation, au moins un mot d'information ou de redondance et un code détecteur d'erreur.

6. Procédé selon la revendication 5, pour l'enregistrement d'un bloc sur un support d'information comprenant P pistes en parallèle, chaque groupe dudit bloc comportant p trames, où p est premier avec le nombre de pistes P, caractérisé en ce qu'on répartit les $n_2$ mots d'un ensemble lié sur les P pistes tel que les mots enregistrés sur une même piste sont associés à des vecteurs colonne de la matrice de Hamming qui forment un système linéairement indépendant, et en ce qu'on enregistre le bloc trame par trame, les trames de chaque ensemble de p trames consécutives du bloc étant disposées en parallèle sur les P pistes.

7. Procédé selon la revendication 1, caractérisé en ce que, à la réception, on détermine la validité de chaque bit d'information, ou de redondance en liaison avec les codes détecteur d'erreur associés aux mots d'information ou de redondance, on calcule, pour chaque ensemble de $n_2$ bits liés, le syndrome associé à cet ensemble, on déduit dudit syndrome et des informations de validité relatives à chaque bit un vecteur d'erreur en relation avec le code de Hamming utilisé et on corrige chaque vecteur de $n_2-k$ bits reçu par ce vecteur d'erreur.

8. Procédé selon la revendication 7, caractérisé en ce que, pour calculer le vecteur d'erreur d'un vecteur de $n_2-k$ bits liés, on définit une matrice réduite (H') constituée par les vecteurs colonne de la matrice de Hamming (H) utilisée à l'émission dont les rangs sont égaux à ceux des bits liés invalidés par les codes détecteur d'erreur, et on en déduit une autre matrice ($H'^1$, H") telle que le produit de cette autre matice par le syndrome soit égal au vecteur d'erreur.

9. Procédé selon l'une quelconque des revendications 7 et 8, caractérisé en ce que, pour chaque ensemble de bits liés, on utilise le syndrome, lorsqu'il n'est pas nul, pour détecter des bits erronés non invalidés par les codes détecteur d'erreur.

10. Procédé selon la revendication 7, dans lequel les mots d'information et de redondance sont émis en trame, caractérisé en ce qu'on détecte la validité d'une trame reçue en relation avec son code détecteur d'erreur et en ce que, pour chaque ensemble de trames liées, on définit une matrice réduite (H') constituée par les vecteurs colonne de la matrice de Hamming (H) utilisée à l'émission dont les rangs sont égaux à ceux des trames liées invalidées par les codes détecteur d'erreur, et on déduit une autre matrice (H'⁻¹, H") unique pour chaque ensemble de trames liées telle que le produit de cette autre matrice par un syndrome non nul est égal au vecteur d'erreur.

**11.** Procédé selon la revendication 10, caractérisé en ce qu'on mémorise au moins certains syndromes non nuls associés à des ensembles de bits liés des trames liées, et en ce qu'on utilise lesdits syndromes non nuls pour détecter des trames erronées non invalidées par les codes détecteur d'erreur.

**Claims**

**1.** Process for the transmission in blocks of digital information words, each having a length of $n_1$ bits, in which $n_1$ is an integer, said process comprising successively adding to the information words to be transmitted words of an error correcting code and words of an error detecting code, wherein the error correcting code is a Hamming code by means of which k redundancy words are added to each sequence of $n_2$-k ($n_2$>k) consecutive information words, said $n_2$-k information words forming with the k redundancy words a set of words called the linked set, each redundancy word having $n_1$ bits and, for each order i, in which $1<i<n_1$ , the k bits of order i of the redundancy words are redundancy bits of the $n_2$-k bits of order i of the $n_2$-k information words, said coding being performed by Hamming matrix, whose column vectors are chosen in such a way as to permit the correction of a given subset of possible errors and the error detecting code is applied to sequences of information words or to sequences of redundancy words, the words of a same sequence belonging to different linked sets, each transmitted block comprising a plurality of sequences of $n_2$-k information words and the associated error detecting and correcting code words, characterized in that for a signal recorded on a support with P parallel tracks, the k redundancy bits associated with $n_2$-k information bits are produced by using a Hamming matrix with $n_2$ columns and k rows, in which any sequence of k vectors of index i, $i+P, i+2P,..., i+(k-1)P$, in which i, P are integers and $i+(k-1)P≤n_2$ forms an independent linear system, each set connected to a block being distributed over several tracks, so that a code word is distributed over several tracks, whilst several elements of said word are recorded on the same track.

**2.** Process according to claim 1 for recording a block on an information medium comprising P parallel recording tracks, characterized in that the $n_2$ words of a linked set are distributed over the P tracks, so that the words recorded on the same track are associated with column vectors of the Hamming matrix forming a linearly independent system.

**3.** Process according to claims 1 or 2, characterized in that, after associating k redundancy words with $n_2$-k information words for forming a set of linked words, the words of $n_3$ linked sets are interlaced to form a transmission block constituted by $n_2$, each group containing one word of each linked set and at lease one error detecting code.

**4.** Process according to claim 3, characterized in that the groups containing redundancy words are placed in the centre of the block, between the groups containing the even information words and the groups containing the uneven information words.

**5.** Process according to any one of the claims 1 to 4, characterized in that each word of a linked set is contained in a frame, each frame comprising a synchronization word, at least one information or redundancy word and an error detecting code.

**6.** Process according to claim 5 for recording a block on an information medium comprising P parallel tracks. each group of said block comprising p frames, in which p is first with the number of tracks P, characterized in that the n2 words of a linked set are distributed over P tracks, so that the words recorded on the same track are associated with column vectors of the Hamming matrix forming a linearly independent system and wherein the block is recorded frame by frame, the frames of each set of p consecutive frames of the block being placed in parallel on the P tracks.

**7.** Process according to claim 1, characterized in that on reception. determination takes place of the validity of each information or redundancy bit linked with the error detecting codes associated with the information or redundancy words and for each set of n2 linked bits, the syndrome associated with said set is calculated and from said syndrome and the validity informations relative to each bit is calculated an error vector related to the Hamming code used and each vector of $n_2$-k bits received is corrected by said error vector.

8. Process according to claim 7, characterized in that, for calculating the error vector of a vector of $n_2$-k linked bits, a reduced matrix (h') constituted by the column vectors of the Hamming matrix (H) used on transmission is defined and whereof the orders are equal to those of the linked bits invalidated by the error detecting codes and from this is deduced another matrix (H'-1, H''), such that the product of said other matrix by the syndrome is equal to the error vector.

9. Process according to either of the claims 7 and 8, characterized in that, for each set of linked bits, use is made of the syndrome, when it is not zero, for detecting the erroneous bits not invalidated by the error detecting codes.

10. Process according to claim 7 in which the information and redundancy words are transmitted in frame, characterized in that detection takes place of the validity of a received frame relative to its error detecting code and wherein for each set of linked frames definition takes place of a reduced matrix (H'') constituted by the column vectors of the Hamming matrix (H) used on transmission and whereof the orders are equal to those of the linked frames invalidated by the error detecting codes and deduction takes place of another single matrix (H'-1, H'') for each set of linked frames, so that the product of this other matrix by a non-zero syndrome is equal to the error vector.

11. Process according to claim 10, characterized in that at least certain non-zero syndromes associated with sets of linked bits of linked frames are stored and in that said non-zero syndromes are used for detecting erroneous frames not invalidated by the error detecting codes.

## Ansprüche

1. Verfahren zum Übertragen digitaler Information in wörterblöcken, von denen jeder eine Länge von $n_1$ Bits besitzt, wo $n_1$ eine ganze Zahl ist, wobei das verfahren darin besteht, sukzessive den zu übertragenden Informationswörtern Wörter eines Fehlerkorrekturcodes und Wörter eines Fehlerdetektorcodes hinzuzufügen; wobei in diesem Verfahren:
   - der Fehlerkorrekturcode ein Hammingcode ist, mittels dessen man k Redundanzwörter jeder Folge von $n_2$-k ($n_2>$k) aufeinanderfolgenden Informationswörtern hinzufügt, wobei die $n_2$-k Informationswörter mit den k Redundanzwörtern eine Wörteranordnung bilden, die verbundene Anordnung genannt wird, wobei jedes Redundanzwort $n_1$ Bits besitzt und für jeden Rang i, wobei $1 \leq i \leq n_1$, die k Bits des Rangs i der Redundanzwörter Redundanzbits der $n_2$-k Bits des Rangs i der $n_2$-k Informationswörter sind, wobei die Codierung durch eine Hammingmatrix durchgeführt wird, deren Spaltenvektoren so ausgewählt sind, daß eine Korrektur einer bestimmten Untermenge von möglichen Fehlern ermöglicht wird,
   - der Fehlerdetektorcode auf Folgen von Informationswörtern oder auf Folgen von Redundanzwörtern angewandt wird, wobei die Wörter einerselben Folge verschiedenen verbundenen Anordnungen angehören, wobei jeder übertragene Block eine Mehrzahl von Folgen mit $n_2$-k Informationswörtern und den damit verbundenen Wörtern des Fehlerdetektorcodes und des Fehlerkorrekturcodes umfaßt, dadurch gekennzeichnet, daß für ein auf einem Träger mit P parallelen Spuren aufgenommenes Signal die k Redundanzbits, die mit den $n_2$-k Informationsbits verbunden sind, erzeugt werden unter Verwendung einer Hammingmatrix mit $n_2$ Spalten und k Zeilen, von der sofort k Zeigervektoren i, i+P, i+2P,..., i+(k-1)P, wo 1,P ganze Zahlen und i+(k-1)P$\leq n_2$ sind, ein linear unabhängiges System bilden, wobei jede verbundene Anordnung eines Blocks auf mehrere Spuren verteilt ist, wobei ein Codierwort so auf mehrere Spuren verteilt ist, während mehrere Elemente des Worts auf der gleichen Spur aufgenommen sind.

2. Verfahren nach Anspruch 1 zur Aufnahme eines Blocks auf einen Informationsträger mit P parallelen Aufnahmespuren, dadurch gekennzeichnet, daß man die $n_2$ Wörter einer verbundenen Anordnung derart auf die P Spuren verteilt, daß die auf derselben Spur aufgenommenen Wörter mit Spaltenvektoren der Hammingmatrix, die ein linear unabhängiges System bilden, verbunden sind.

3. Verfahren nach Anspruch 1 oder 2, dadurch gekennzeichnet, daß man nach dem Verbinden von k

17

Redundanzwörtern mit $n_2$-k Informationswörtern, um eine Anordnung von verbundenen Wörtern herzustellen, die Wörter von $n_3$ verbundenen Anordnungen verkettet, um einen aus $n_2$ Gruppen bestehenden Ausgabeblock zu bilden, wobei jede Gruppe ein Wort aus jeder verbundenen Anordnung und wenigstens einen Fehlerdetektorcode enthält.

4. Verfahren nach Anspruch 3, dadurch gekennzeichnet, daß die Gruppen, die Redundanzwörter enthalten, in der Blockmitte zwischen den Gruppen, die gerade Informationswörter, und den Gruppen, die ungerade Informationswörter enthalten, angeordnet sind.

5. Verfahren nach einem der Ansprüche 1 bis 4, dadurch gekennzeichnet, daß jedes Wort einer verbundenen Anordnung in einem Teilbild enthalten ist, wobei jedes Teilbild ein Synchronisationswort, wenigsten ein Informationswort oder Redundanzwort und einen Fehlerdetektorcode enhält.

6. Verfahren nach Anspruch 5 zur Aufnahme eines Blocks auf einen Informationsträger mit P parallelen Aufnahmespuren, wobei jede Gruppe des Blocks p Teilbilder enthält, wobei p mit der Zahl der Spuren P zuerst ist, dadurch gekennzeichnet, daß man die $n_2$ Wörter einer verbundenen Anordnung derart auf die P Spuren verteilt, daß die auf derselben Spur aufgenommenen Wörter mit Spaltenvektoren der Hammingmatrix, die ein linear unabhängiges System Teilbilden, verbunden sind, und daß man den Block Teilbild für Teilbild aufnimmt, wobei die Teilbilder jeder Anordnung aus p aufeinanderfolgenden Teilbildern des Blocks parallel auf den P Spuren angeordnet sind.

7. Verfahren anch Anspruch 1, dadurch gekennzeichnet, daß man bei der Aufnahme die Gültigkeit jedes Informationsbits oder Redundanzbits in Verbindung mit den mit den Informationswörtern oder Redundanzwörtern verbundenen Fehlerdetektionscodes bestimmt, man für jede Anordnung aus $n_2$ verbundenen Bits die mit dieser Anordnung verbundene Verknüpfung berechnet, daß man von der Verknüpfung und den auf jedes Bit bezogenen Gültigkeitsinformationen einen Fehlervektor bezogen auf den verwendeten Hammingcode ableitet und daß man jeden Vektor von $n_2$-k empfangenen Bits durch diesen Fehlervektor korrigiert.

8. Verfahren nach Anspruch 7, dadurch gekennzeichnet, daß man zum Berechnen des Fehlervektors für einen Vektor aus $n_2$-k verbundenen Bits eine reduzierte Matrix (H') definiert, die aus den Spaltenvektoren der bei der Ausgabe verwendeten Hammingmatrix (H) besteht, deren Ränge gleich denen der durch den Fehlerdetektionscode ungültig erklärten, verbundenen Bits sind, und daß man daraus eine weitere Matrix ($H'^{-1}$, H'') herleitet, so daß das Produkt dieser weiteren Matrix mit der Verknüpfung gleich dem Fehlervektor ist.

9. Verfahren nach einem der Ansprüche 7 und 8, dadurch gekennzeichnet, daß man für jede Anordnung verbundener Bits die Verknüpfung verwendet, wenn sie nicht Null ist, um fehlerhafte Bits zu detektieren, die nicht durch den Fehlerdetektionscode ungültig gemacht wurden.

10. Verfahren nach Anspruch 7, bei dem die Informationswörter und Redundanzwörter in Teilbildern ausgegeben werden, dadurch gekennzeichnet, daß man die Gültigkeit eines empfangenen Teilbilds in Verbindung mit seinem Fehlerdetektionscode detektiert und daß man für jede Anordnung verbundener Teilbilder eine reduzierte Matrix (H') definiert, die aus den Spaltenvektoren der bei der Ausgabe verwendeten Hammingmatrix (H) besteht, deren Ränge gleich denen der durch den Fehlerdetektionscode ungültig erklärten, verbundenen Teilbilder sind, und daß man daraus eine weitere Matrix ($H'^{-1}$, H''), die für jede Anordnung von verbundenen Teilbildern eindeutig ist, herleitet, so daß das Produkt dieser weiteren Matrix mit der Verbindung gleich dem Fehlervektor ist.

11. Verfahren nach Anspruch 10, dadurch gekennzeichnet, daß man wenigstens bestimmte Verknüpfungen, die nicht Null sind und mit Anordnungen von mit verbundenen Teilbildern verbundenen Bits verbunden sind, speichert, und daß man diese Verknüpfungen, die nicht Null sind, verwendet, um fehlerhafte Teilbilder zu entdecken, die nicht vom Fehlerdetektionscode ungültig gemacht wurden.

FIG. 1

EP 0 204 635 B1

FIG. 2

EP 0 204 635 B1

**FIG. 3**

| $G_1$ | $K_2$ | $J_3$ | $H_4$ | $G_5$ | $K_6$ | $J_7$ | $H_8$ | $G_9$ | $K_{10}$ | $J_{11}$ | $H_{12}$ | $G_{13}$ | $K_{14}$ | $J_{15}$ | $H_{16}$ |
| $H_1$ | $G_2$ | $K_3$ | $J_4$ | $H_5$ | $G_6$ | $K_7$ | $J_8$ | $H_9$ | $G_{10}$ | $K_{11}$ | $J_{12}$ | $H_{13}$ | $G_{14}$ | $K_{15}$ | $J_{16}$ |
| $J_1$ | $H_2$ | $G_3$ | $K_4$ | $J_5$ | $H_6$ | $G_7$ | $K_8$ | $J_9$ | $H_{10}$ | $G_{11}$ | $K_{12}$ | $J_{13}$ | $H_{14}$ | $G_{15}$ | $K_{16}$ |
| $K_1$ | $J_2$ | $H_3$ | $G_4$ | $K_5$ | $J_6$ | $H_7$ | $G_8$ | $K_9$ | $J_{10}$ | $H_{11}$ | $G_{12}$ | $K_{13}$ | $J_{14}$ | $H_{15}$ | $G_{16}$ |

**FIG. 4**

| $G_1 T_1$ | $G_2 T_2$ | $G_3 T_3$ | $G_5 T_1$ | $G_6 T_2$ | $G_7 T_3$ | $G_9 T_1$ | $G_{10} T_2$ | $G_{11} T_3$ | $G_{13} T_1$ | $G_{14} T_2$ | $G_{15} T_3$ |
| $G_1 T_2$ | $G_2 T_3$ | $G_4 T_1$ | $G_5 T_2$ | $G_6 T_3$ | $G_8 T_1$ | $G_9 T_2$ | $G_{10} T_3$ | $G_{12} T_1$ | $G_{13} T_2$ | $G_{14} T_3$ | $G_{16} T_1$ |
| $G_1 T_3$ | $G_3 T_1$ | $G_4 T_2$ | $G_5 T_3$ | $G_7 T_1$ | $G_8 T_2$ | $G_9 T_3$ | $G_{11} T_1$ | $G_{12} T_2$ | $G_{13} T_3$ | $G_{15} T_1$ | $G_{16} T_2$ |
| $G_2 T_1$ | $G_3 T_2$ | $G_4 T_3$ | $G_6 T_1$ | $G_7 T_2$ | $G_8 T_3$ | $G_{10} T_1$ | $G_{11} T_2$ | $G_{12} T_3$ | $G_{14} T_1$ | $G_{15} T_2$ | $G_{16} T_3$ |

FIG. 5

FIG. 6

EP 0 204 635 B1

FIG. 7

$22_1$ $22_2$ $22_{11}$ $22_{12}$ $22_{13}$ $22_{14}$ $22_{15}$ $22_{16}$ 48 50 $52_{12}$ $52_{13}$ $52_{14}$ $52_{15}$ $52_{16}$

OPERATEUR DE PARITE

56

30

38 D

40 D

16

5

5

MICROPROCESSEUR

DONNEES

5

ADRESSE

4

RAM
COEFFICIENTS
CORRECTION

54

ADRESSE

4

4

SYNC.

SEQUENCEUR

58

EP 0 204 635 B1